# EUROPEAN PATENT APPLICATION

(11) **EP 2 587 519 A2**
(43) Date of publication of application: **01.05.2013**
(21) Application number: 12189677.3
(22) Date of filing: 24.10.2012
(51) Int. Cl.: H01J 37/34

(54) **Film formation apparatus and film formation method**

(30) Priority: 28.10.2011 JP 2011237311
(71) Applicant: Kabushiki Kaisha Kobe Seiko Sho, Chuo-ku Kobe-shi Hyogo 651-8585 (JP)
(72) Inventor: Hirota, Satoshi, Takasago-shi, Hyogo 676-8670 (JP); Yamamoto, Kenji, Kobe-shi, Hyogo 651-2271 (JP); Tamagaki, Hiroshi, Takasago-shi, Hyogo 676-8670 (JP)
(74) Representative: TBK

(57) **Abstract**

A film formation apparatus of the present invention has two sputtering evaporation sources each of which includes an unbalanced magnetic field formation means formed by an inner pole magnet arranged on the inner side and an outer pole magnet arranged on the outer side of this inner pole magnet, the outer pole magnet having larger magnetic line density than the inner pole magnet, and a target arranged on a front surface of the unbalanced magnetic field formation means, and further has an AC power source for applying alternating current whose polarity is switched with a frequency of 10 kHz or more between the targets of the two sputtering evaporation sources so as to generate discharge between both the targets and perform film formation.

## Description

### BACKGROUND OF THE INVENTION

### (FIELD OF THE INVENTION)

The present invention relates to a film formation apparatus and a film formation method for performing vacuum film formation on a surface of a substrate with using sputter and CVD.

### (DESCRIPTION OF THE RELATED ART)

Conventionally, for a purpose of improving abrasion resistance of a cutting tool and improving a sliding characteristic of a sliding surface of a mechanical part, a hard film (of TiN, TiAlN, CrN, or the like) is formed on a substrate (film formation object) by a physical vapor deposition (PVD) method. As an apparatus used for forming such a hard film, there are film formation apparatuses such as an arc ion plating apparatus and a sputtering apparatus.

The apparatus for performing sputtering among such film formation apparatuses is preferably used as a formation means of a film having a smooth surface. However, ion irradiation is frequently unsatisfactorily performed to the substrate during the film formation. In order to obtain favorable productivity, an ionization rate is indispensably increased so as to increase film formation speed. One of means for increasing such an ionization rate is to adopt UBMS (Unbalanced Magnetron Sputter) for intentionally bringing a magnetic field of a magnetron sputter source into an unbalanced state.

As shown in Japanese Unexamined Patent Application Publication No. 2000-282235 and Japanese Unexamined Patent Application Publication No. 2000-119843, the UBMS has a magnetic field formation means (magnetron) on the back surface side of the target as well as BMS (Balanced Magnetron Sputter), and a magnetic field is formed in front of the target by an operation of this magnetic field formation means, so that ions are irradiated with directivity along the formed magnetic field. This UBMS is different from the BMS in a point that an inner pole magnet forming the magnetic field formation means and an outer pole magnet arranged on the outer side of this inner pole magnet are arranged in such a manner that magnetic poles which are different from each other face a work, and the magnetic field formation means is formed in such a manner that magnetic density of the outer pole magnet is higher than that of the inner pole magnet.

When the magnetic density of the outer pole magnet is higher than that of the inner pole magnet in such a way, the magnetic field extending toward the front side of the target, in other words, toward the work can be formed. An ion irradiation amount to the substrate can be increased in comparison to a case of using a magnetic field formation means of the BMS having no difference in magnetic density between an inner pole magnet and an outer pole magnet.

The UBMS described above is to form a strong magnetic field in front of the target in such a manner that the magnetic field extends toward the work, and is effective as a means for increasing the ion irradiation amount to the substrate.

However, even in a case of using the UBMS, for example when the hard film described above or the like is formed, a situation that it cannot be said that ionization is sufficiently performed is generated, and hence there is sometimes a case where the film formation with favorable film quality cannot be performed.

### SUMMARY OF THE INVENTION

The present invention is achieved in consideration with the above problem, and an object thereof is to provide a film formation apparatus and a film formation method capable of sufficiently performing ion irradiation to a substrate during film formation so as to obtain a favorable ionization rate.

In order to solve the above problem, a film formation apparatus of the present invention includes the following technical means.

That is, the present invention is a film formation apparatus including a vacuum chamber, and two sputtering evaporation sources arranged in the vacuum chamber, each of the sputtering evaporation sources including an unbalanced magnetic field formation means formed by an inner pole magnet arranged on the inner side and an outer pole magnet arranged on the outer side of the inner pole magnet, the outer pole magnet having larger magnetic line density than the inner pole magnet, and a target arranged on a front surface of the unbalanced magnetic field formation means, wherein the film formation apparatus has an AC power source, and the AC power source applies alternating current whose polarity is switched with a frequency of 10 kHz or more between the target of one of the sputtering evaporation sources and the target of the other sputtering evaporation source among the two sputtering evaporation sources.

Preferably, the one pair of sputtering evaporation sources may be adjacently arranged in the vacuum chamber, the inner pole magnets of the adjacent sputtering evaporation sources may have the same pole as each other, and the outer pole magnets may have the same pole as each other.

Preferably, a shutter covering a front surface of the target may be openably and closably provided on a front surface of the sputtering evaporation source, and the shutter may have an open angle of 90° or more at the time of full open.

Preferably, a cathodic discharge type arc evaporation source may be provided in the vacuum chamber in addition to the sputtering evaporation sources.

Preferably, a gas supply means for supplying a mixture gas of a reactive gas and an inert gas into the vacuum chamber may be provided.

Meanwhile, a film formation method of the present invention is a film formation method for performing film formation by using the above film formation apparatus, wherein by applying the alternating current by the AC power source, the film formation is performed while discharge is generated between the targets of the two sputtering evaporation sources.

In the above film formation method, by supplying a mixture gas of a reactive gas and an inert gas into the vacuum chamber and ionizing the mixture gas with using the discharge, a CVD film may be formed. The reactive gas may be a nitrogen gas.

By using the film formation apparatus and the film formation method of the present invention, the ion irradiation to the substrate is sufficiently performed during the film formation, so that a favorable ionization rate can be obtained.

### BRIEF DESCRIPTION OF THE DRAWINGS

Fig. 1 is a view showing a film formation apparatus of the present embodiment;
Fig. 2 is a view showing distribution of magnetic lines generated in the film formation apparatus of the present embodiment;
Fig. 3 is a view showing distribution of magnetic lines generated in the film formation apparatus of a modified example of the present embodiment;
Fig. 4 is a view showing distribution of magnetic lines generated in the film formation apparatus of a modified example of the present embodiment;
Fig. 5 is a view showing distribution of magnetic lines generated in the film formation apparatus of a modified example of the present embodiment; and
Fig. 6 is a view showing distribution of magnetic lines generated in a film formation apparatus of a conventional example.

### DESCRIPTION OF THE PREFERRED EMBODIMENTS

Hereinafter, a film formation apparatus according to the present invention will be described in detail based on the drawings.

A film formation apparatus 1 of the present embodiment is an apparatus for covering surfaces of substrates W installed in a vacuum chamber 2 having an octagonal section with a film by a physical vapor deposition method (PVD method). In substantially center of a bottom surface in the vacuum chamber 2, a rotation type work table 3 on which the plurality of substrates W serving as objects to be processed is disposed is provided. Sputtering evaporation sources 4 are respectively arranged on two or more inner circumferential surfaces among a plurality of inner circumferential surfaces of the vacuum chamber 2.

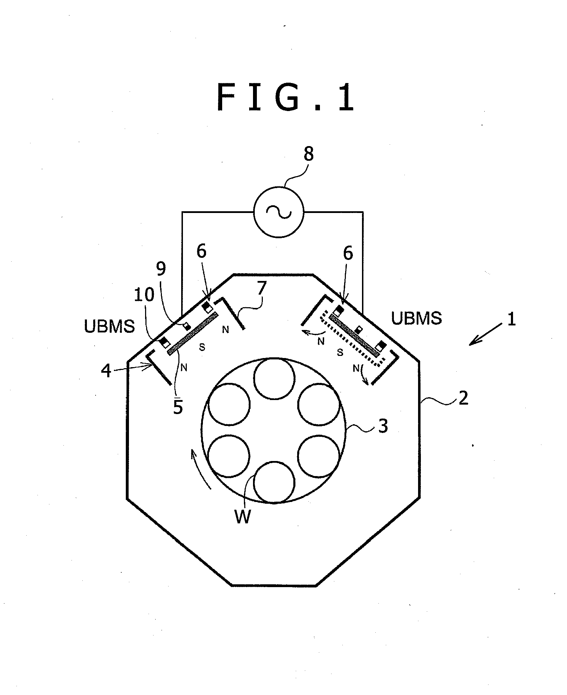

The vacuum chamber 2 of the present embodiment has an octagonal section. Thus, the vacuum chamber has eight inner circumferential surfaces in total. The sputtering evaporation sources 4 are arranged on two inner circumferential surfaces sandwiching one inner circumferential surface among these eight inner circumferential surfaces. That is, with arrangement of Fig. 1, the two sputtering evaporation sources 4 in total are arranged on the two inner circumferential surfaces on the left upper side and on the right upper side among the eight inner circumferential surfaces.

Each of the sputtering evaporation sources 4 has a plate shape target 5 arranged so as to directly face the substrates W, and an unbalanced magnetic field formation means 6. This unbalanced magnetic field formation means 6 is arranged on the back surface side of the target 5 (on the side not facing the substrates W), so as to form a magnetic field with directivity on the front surface side of the target (on the side directly facing the substrates W).

On the outer side of the sputtering evaporation source 4, a shutter 7 covering a front surface of the target 5 is openably and closably provided. This shutter 7 includes two left and right members, and is openable and closable leftward and rightward when seen from the side directly facing the target 5 by rotating the members. An open angle of the shutter 7 at the time of full open is set to be 90° or more with respect to a surface of the target 5. That is, the shutter 7 is opened outward in such a manner that an opening of the shutter 7 is gradually spread from the target 5 toward the substrates W at the time of full open. As shown by a dotted line regarding the right upper sputtering evaporation source 4 in Fig. 1, when the shutter 7 is fully closed, the entire surface of the target 5 is covered by the shutter 7.

As described above, the two sputtering evaporation sources 4 in total are arranged in the vacuum chamber 2. In the present embodiment, the sputtering evaporation sources 4 are respectively arranged on the left upper side and on the right upper side of the vacuum chamber 2, and an AC power source 8 described later is connected between the sputtering evaporation sources 4. Unlike the present embodiment, two or more sputtering evaporation sources 4 can be arranged, plural pairs of two sputtering evaporation sources 4 can be provided, and an AC or bipolar power source can be connected to the plural pairs respectively.

The target 5 is formed by processing metal serving as a material of the film to be formed on the substrates W into a plate shape. For example, in a case where a hard film of TiN, TiAlN, CrN, or the like is formed, a metal plate of Ti, TiAl alloy, Cr, or the like. One pole of the AC power source 8 is connected to this target 5.

The unbalanced magnetic field formation means 6 is formed by an inner pole magnet 9 arranged on the inner side and outer pole magnets 10 arranged on the outer side of this inner pole magnet 9, the outer pole magnets having larger magnetic line density (magnetic flux density) than the inner pole magnet 9, so as to serve as magnetic field formation means for UBMS. Both the inner pole magnet 9 and the outer pole magnets 10 are permanent magnets or electromagnets such as neodymium magnets, and the magnets are arranged in such a manner that any one of magnetic poles faces the substrates W. For the outer pole magnet, a magnet having a larger sectional area than the inner pole magnet is used in order to increase the magnetic line density, and a degree of an unbalanced magnetic field is determined by a ratio of the sectional area. In general, the ratio of the sectional area of the outer pole magnet is about 1.5 to 2 times more than that of the inner pole magnet.

When the sputtering evaporation sources 4 of the UBMS provided with the unbalanced magnetic field formation means 6 are used in such a way, magnetic lines on the front surface side of the targets 5 can be strengthened in comparison to the back surface side, so that the magnetic lines can be preferentially directed toward the front surface side of the targets 5.

The film formation apparatus 1 of the present invention is characterized by that the above two sputtering evaporation sources 4 serve as one pair, and alternating current whose polarity is switched with a frequency of 10 kHz or more is applied between the target 5 of one of the sputtering evaporation sources 4 and the target 5 of the other sputtering evaporation source 4 by using the AC power source 8.

For this AC power source 8, a device capable of generating current whose polarity is reversed such as a bipolar power source can be used. For the alternating current, not only current whose polarity is reversed with a sine waveform but also pulse current whose polarity is reversed with a rectangular waveform or the like can be used. From this AC power source 8, high-frequency alternating current of 10 kHz or more, more preferably, high-frequency alternating current of 20 kHz or more is given.

In a case where the film is formed on the surfaces of the substrates W by using the above film formation apparatus 1, the film formation is executed by the following procedure.

As described above, the two sputtering evaporation sources 4 having the unbalanced magnetic field formation means 6 formed by the inner pole magnet 9 arranged on the inner side and the outer pole magnets 10 arranged on the outer side of this inner pole magnet 9, the outer pole magnets having larger magnetic line density than the inner pole magnet 9 on the back surface side of the targets 5 are prepared. The sputtering evaporation sources 4 are respectively arranged on the plurality of inner circumferential surfaces in the vacuum chamber 2 in which the film formation is performed. In the example of Fig. 1, the sputtering evaporation sources 4 are attached to two points of the inner circumferential surfaces on the left upper side and on the right upper side. Then, the alternating current whose polarity is switched with a frequency of 10 kHz or more is applied between the targets 5 of the two sputtering evaporation sources 4.

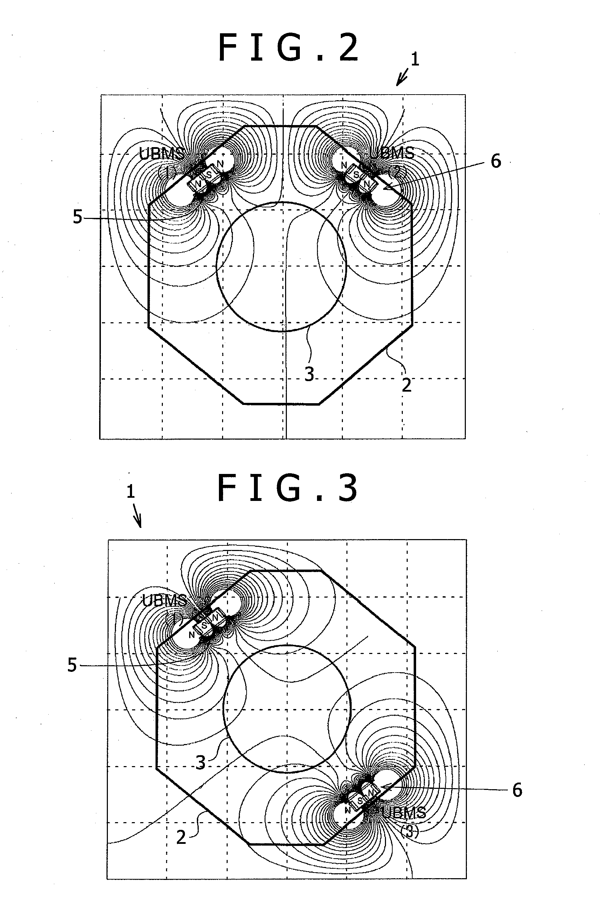

In such a way, a potential difference is generated between the targets 5 of the two sputtering evaporation sources 4 by an operation of the AC power source 8, and discharge is generated from the target 5 of one of the sputtering evaporation sources 4 toward the target 5 of the other sputtering evaporation source 4. This discharge is generated in such a manner that a frequency is the same as a frequency of the given alternating current and the directions alternate with each other. At this time, discharge electrons are actively moved along magnetic lines generated between the respective unbalanced magnetic field formation means 6 (magnetic lines as shown in Fig. 2). As a result, ionization of a sputter gas existing between the sputtering evaporation sources 4 is facilitated, and an ion irradiation amount to the substrates W is increased, so that a minute film can be formed on the surfaces of the substrates W. This increase in the ion irradiation amount is more than a case of one sputtering evaporation source 4. When the frequency of the given alternating current is 10 kHz or more, more preferably, 20 kHz or more, the ion irradiation amount can be further increased.

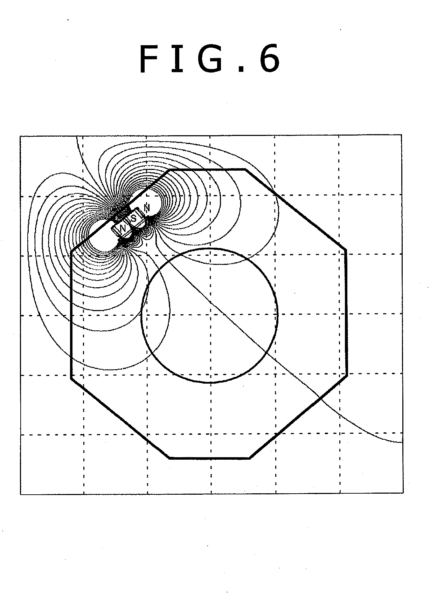

The increase in the ion irradiation amount to the substrates W described above is confirmed not only with arrangement of the sputtering evaporation sources 4 as in Fig. 2 but also with arrangement of the sputtering evaporation sources 4 as shown in Figs. 3 to 5. In a case where the alternating current of 10 kHz or more is applied between the sputtering evaporation sources of the arrangement shown in these figures, an effect of increasing ion irradiation can also be exerted in comparison to a conventional example of Fig. 6 (of one sputtering evaporation source 4).

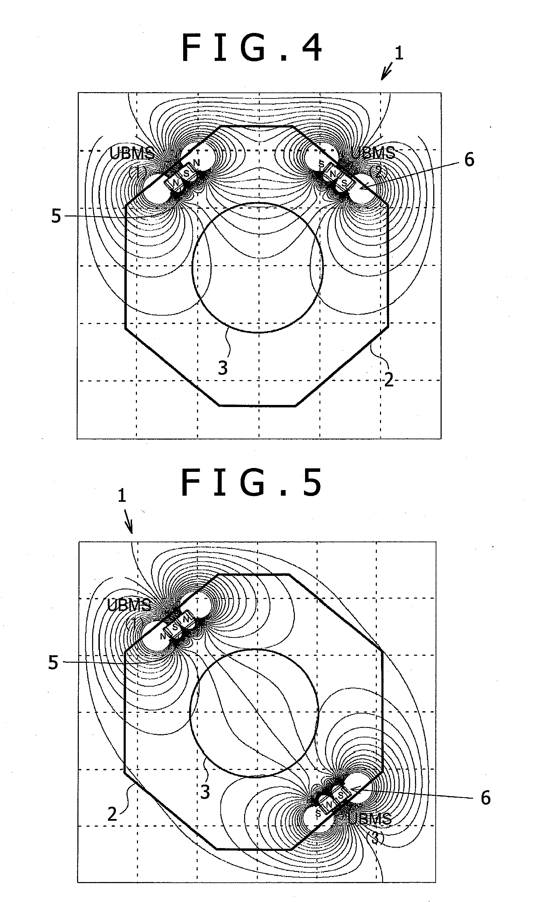

Specifically, in Figs. 2 and 4, the two sputtering evaporation sources 4 in total are provided on inner circumferential surfaces on the left side and on the right side sandwiching one inner circumferential surface among the eight inner circumferential surfaces. In Figs. 3 and 5, the two sputtering evaporation sources 4 in total are provided on inner circumferential surfaces facing each other among the eight inner circumferential surfaces.

In comparison to Figs. 4 and 5, Figs. 2 and 3 show such arrangement that directivity of poles of the inner pole magnet 9 and the outer pole magnets 10 of the unbalanced magnetic field formation means 6 are the same as each other, that is, the magnetic lines coming from the inner pole magnet 9 and the outer pole magnets 10 of one of the unbalanced magnetic field formation means 6 do not directly enter (keep away from) the inner pole magnet 9 and the outer pole magnets 10 of the other unbalanced magnetic field formation means 6. As clear from distribution of the magnetic lines shown in the figures, the arrangement that the magnetic lines keep away from each other as in Figs. 2 and 3 is determined to have a larger effect of increasing the ion irradiation than Figs. 4 and 5.

In addition to the above sputtering evaporation sources 4, one or more cathodic discharge type arc evaporation source (not shown) can be provided in the vacuum chamber 2. In such a way, the film can be formed on the surfaces of the substrates W with using an arc ion plating method by using the film formation apparatus 1.

When a gas supply means (not shown) for supplying and discharging a gas into and from the vacuum chamber 2 is provided, by supplying a mixture gas of a reactive gas and an inert gas and ionizing this mixture gas with using the discharge, a compound film in which a target material and the reactive gas react on each other can be formed. At this time, when the reactive gas is a nitrogen gas, a nitride reactive film (film of TiN, TiAlN, CrN, or the like) can be formed. When the reactive gas is a methane gas, a carbide reactive film (TiC, CrC) can be formed. In such a way, by supplying the reactive gas of nitrogen, carbon hydride, oxygen, or the like in addition to the inert gas, ionization of these reactive gases is facilitated, so that a minute compound film which is closer to stoichiometric composition can be formed.

### [Example]

Next, operations and effects of the film formation apparatus 1 of the present invention will be described further in detail with using Example.

The film formation was performed by using the film formation apparatus 1 in which the two sputtering evaporation sources 4 were attached to the inner circumferential surfaces of the vacuum chamber 2 having an octagonal section. It should be noted that regarding the two sputtering evaporation sources 4, the sputtering evaporation source positioned on the left upper side of the vacuum chamber 2 in Fig. 1 corresponds to an "evaporation source 1" in Table 1, the sputtering evaporation source positioned on the right upper side of the vacuum chamber 2 corresponds to an "evaporation source 2", and the sputtering evaporation source positioned on the right lower side (not shown) corresponds to an "evaporation source 3".

The targets 5 of type shown in Table 1 (Ti + Al) were attached to the sputtering evaporation sources 4, and the film formation was performed. Size of the target 5 is 127 × 508 mm, and the magnetic field formation means including a neodymium magnet for generating a balanced magnetic field (BM) or an unbalanced magnetic field (UBM) is provided on a back surface. In the film formation apparatus 1 provided with the sputtering evaporation sources 4, the work table 3 in which six pipes (substrates W) made of SUS304 of ϕ130 × 600 mm are installed is provided, and this work table 3 is rotated at 3 rpm during the film formation.

An argon gas serving as a sputter gas was inputted at the time of the film formation by 120 cc/min (sccm) converted as a standard state, and nitrogen serving as the reactive gas was supplied by an amount to be matched with discharge power. It should be noted that pressure in the vacuum chamber 2 at the time of the film formation was about 0.6 Pa, and a temperature was 400°C.

Under the film formation conditions as described above, the film was formed on the substrates W by using film formation apparatuses of Conventional Example and the film formation apparatus 1 of Example, values of substrate current applied at the time of the film formation were measured, and an ionization degree was determined. As Conventional Example, examples that the film formation was performed by an apparatus in which a DC power source is connected to magnetic field formation means for generating the balanced magnetic field (BM) (conventional examples 1, 2), examples that the film formation was performed by an apparatus in which a DC power source is connected to magnetic field formation means for generating the unbalanced magnetic field (UBM) (conventional examples 3, 4), and examples that the film formation was performed by an apparatus in which an AC power source is connected to magnetic field formation means for generating the balanced magnetic field (BM) (conventional examples 5, 6) were executed.

In a case where the film formation was performed by the apparatuses of the conventional examples (1 to 4) under the conditions shown in Table 1, stable discharge can be generated until an upper limit of input power is 2.5 kW per one evaporation source. However, in a case where the input power exceeds 2.5 kW, arcing (phenomenon that not normal glow discharge but abnormal arc discharge is caused) was generated on the surfaces of the targets 5. In the conventional examples 5, 6, since the AC power source is connected, stable discharge can be generated. However, since the sputtering evaporation sources do not generate the unbalanced magnetic field, the ionization is insufficient, and the values of current applied to the substrates are low. In such a way, in Conventional Example, as clear from Table 1, the values of the substrate current under the conditions enabling stable discharge are low, and the values are not preferable as a sputtering condition.

However, in a case of examples 1 to 8 that the alternating current is applied to the sputtering evaporation sources 4 provided with the magnetic field formation means 6 for generating the unbalanced magnetic field (UBM), even when the input power is 8 kW per one evaporation source, stable discharge without arcing could be generated. As clear from Table 1, the values of the substrate current under the conditions enabling stable discharge are sufficiently higher values than Conventional Example, and the values are preferable as the sputtering condition. From this, it is found that by applying the alternating current between the targets 5 of the two magnetic field formation means 6 for generating the unbalanced magnetic field (UBM), stable discharge (ion irradiation) without arcing can be generated to the substrates during the film formation, so that a favorable ionization rate can be obtained.

A comparative example 1 is an example that a frequency of a connected AC power source is less than 10 kHz. When the comparative example 1 is compared with the example 5 under the same conditions other than the frequency of the AC power source, the values of the substrate current are larger in the example 5. In the comparative example 1, only the values of the substrate current of the conventional example are obtained. This result indicates significance for the frequency of the AC power source to be 10 kHz or more.

When the example 1 and the example 2 are compared, the values of the substrate current are larger in the example 1 that the inner pole magnets of the two sputtering evaporation sources have the same pole as each other and the outer pole magnets have the same pole as each other than the example 2 that the inner pole magnets of the two sputtering evaporation sources have different poles from each other and the outer pole magnets have different poles from each other. From this result, it is found that more preferably, the inner pole magnets of the two sputtering evaporation sources have the same pole as each other and the outer pole magnets have the same pole as each other.

### [Table 1]

Meanwhile, after the same film formation conditions as the example 1 of Table 1 were set, and the open angle of the shutter 7 was set as 80°, 90°, 120°, 135°, and 180°, the values of the current applied to the substrates W at the time of the discharge were measured similarly to the case of Table 1. The open angle indicates an angle made by both the left and right plate shape members covering the front surface of the target with respect to the surface of the target 5 when the shutter 7 is closed. Results are shown in Table 2.

### [Table 2]

From Table 2, it is found that when the open angle of the shutter 7 is 90° or more, large ion current can be stably generated to the substrates W during the film formation, so that a favorable ionization rate can be obtained. A reason that the ion current is increased in such a way is thought to be that in a case where the open angle of the shutter 7 is 90° or more, the electrons taken onto a leakage flux in front of the target 5 are not blocked by the shutter 7 acting as an anode (electrons are not incident on the shutter 7), and as a result, the electrons moved between the sputtering evaporation sources 4 are increased.

As clear from the above description, the two or more sputtering evaporation sources 4 each of which includes the unbalanced magnetic field formation means 6 formed by the inner pole magnet 9 arranged on the inner side and the outer pole magnets 10 arranged on the outer side of this inner pole magnet 9, the outer pole magnets having larger magnetic line density than the inner pole magnet 9, and the target 5 arranged on the front surface of the unbalanced magnetic field formation means 6 are arranged in the vacuum chamber 2 in which the film formation is performed by the sputtering evaporation sources 4. Regarding one or more pair of sputtering evaporation sources among the two or more sputtering evaporation sources, the alternating current whose polarity is switched with a frequency of 10 kHz or more is applied between the targets of the sputtering evaporation sources, and the discharge is generated between both the sputtering evaporation sources 4, so that the film formation is performed. Thus, the ion irradiation to the substrates W is sufficiently performed, so that a favorable ionization rate can be obtained, and the film formation can be reliably performed.

The present invention is not limited to the above embodiment but shapes, structures, materials, combination, and the like of the members can be appropriately changed within a range not changing the essence of the invention. As matters not clearly disclosed in the embodiment disclosed herein such as an operation condition, a running condition, various parameters, and size, weight, and mass of constituents, matters not departing from the range that those skilled in the art normally operates but easily anticipated by those skilled in the art are adopted.

A film formation apparatus of the present invention has two sputtering evaporation sources each of which includes an unbalanced magnetic field formation means formed by an inner pole magnet arranged on the inner side and an outer pole magnet arranged on the outer side of this inner pole magnet, the outer pole magnet having larger magnetic line density than the inner pole magnet, and a target arranged on a front surface of the unbalanced magnetic field formation means, and further has an AC power source for applying alternating current whose polarity is switched with a frequency of 10 kHz or more between the targets of the two sputtering evaporation sources so as to generate discharge between both the targets and perform film formation.

**[Table 1]**

| | | Evaporation source 1 | | | | Evaporation source 2 | | | | Evaporation source 3 | | |
|---|---|---|---|---|---|---|---|---|---|---|---|---|
| | | Magnetic field generation means | | Direction of magnetic field | | Magnetic field generation means | | Direction of magnetic field | | Magnetic field generation means | | Direction of magnetic field |
| Conventional Ex. 1 | | BM | | SNS | | BM | | SNS | | Non | | |
| Conventional Ex. 2 | | BM | | NSN | | BM | | SNS | | Non | | |
| Conventional Ex. 3 | | UBM | | SNS | | UBM | | SNS | | Non | | |
| Conventional Ex. 4 | | UBM | | NSN | | UBM | | SNS | | Non | | |
| Conventional Ex. 5 | | BM | | NSN | | BM | | NSN | | Non | | |
| Conventional Ex. 6 | | BM | | NSN | | BM | | SNS | | Non | | |
| Example 1 | | UBM | | NSN | | UBM | | NSN | | Non | | |
| Example 2 | | UBM | | NSN | | UBM | | SNS | | Non | | |
| Example 3 | | UBM | | NSN | | Non | | | | UBM | | NSN |
| Example 4 | | UBM | | NSN | | Non | | | | UBM | | SNS |
| Comparative Ex. 1 | | UBM | | NSN | | UBM | | NSN | | Non | | |
| Example 5 | | UBM | | NSN | | UBM | | NSN | | Non | | |
| Example 6 | | UBM | | NSN | | UBM | | NSN | | Non | | |
| Example 7 | | UBM | | NSN | | UBM | | NSN | | Non | | |
| Example 8 | | UBM | | NSN | | UBM | | NSN | | Non | | |
| | | | | | | | | | | | | |

| | Connection | | Type of film | | Frequency | | Input power (kW/one evaporation source) | | Type of gas | | Value of substrate current (A) | Value of substrate current/input power (A/kW) |
|---|---|---|---|---|---|---|---|---|---|---|---|---|
| Conventional Ex. 1 | Non | | (Ti0.5Al05)N | | DC | | 3 | | N₂ | | 1 | 0.33 |
| Conventional Ex. 2 | Non | | (%0.5Al05)N | | DC | | 3 | | N₂ | | 1 | 0.33 |
| Conventional Ex. 3 | Non | | (Ti0.5Al05)N | | DC | | 3 | | N₂ | | 2 | 0.67 |
| Conventional Ex. 4 | Non | | (Ti0.5Al05)N | | DC | | 3 | | N₂ | | 2 | 0.67 |
| Conventional Ex. 5 | 1 and 2 | | (Ti0.5Al05)N | | AC 30kHz | | 8 | | N₂ | | 13 | 1.63 |
| Conventional Ex. 6 | 1 and 2 | | (Ti0.5Al05)N | | AC 30kHz | | 8 | | N₂ | | 12 | 1.50 |
| Example 1 | 1 and 2 | | (Ti0.5Al05)N | | AC 30kHz | | 8 | | N₂ | | 22 | 2.75 |
| Example 2 | 1 and 2 | | (Ti0.5Al05)N | | AC 30kHz | | 8 | | N₂ | | 18 | 2.25 |
| Example 3 | 1 and 3 | | (Ti0.5Al05)N | | AC 30kHz | | 8 | | N₂ | | 16 | 2.00 |
| Example 4 | 1 and 3 | | (Ti0.5Al05)N | | AC 30kHz | | 8 | | N₂ | | 17 | 2.13 |
| Comparative Ex. 1 | 1 and 2 | | (Ti0.5Al05)N | | AC 5kHz | | 8 | | N₂ | | 14 | 1.75 |
| Example 5 | 1 and 2 | | (Ti0.5Al05)N | | AC 10kHz | | 8 | | N₂ | | 17 | 2.13 |
| Example 6 | 1 and 2 | | (Ti0.5Al05)N | | AC 50kHz | | 8 | | N₂ | | 24 | 3.00 |
| Example 7 | 1 and 2 | | (Ti0.5Al05)N | | AC 100kHz | | 8 | | N₂ | | 24 | 3.00 |
| Example 8 | 1 and 2 | | (Ti0.5Al05)N | | Bipolar 50kHz | | 8 | | N₂ | | 23 | 2.88 |

**[Table 2]**

| | Open angle of shutter (°) | Ion current (A) |
|---|---|---|
| Comparative Ex. 1 | 80 | 12 |
| Example 1 | 90 | 17 |
| Example 2 | 120 | 20 |
| Example 3 | 135 | 22 |
| Example 4 | 180 | 23 |

## Claims

1. A film formation apparatus, comprising:
a vacuum chamber; and
two sputtering evaporation sources arranged in said vacuum chamber, each of said sputtering evaporation sources including:
an unbalanced magnetic field formation means formed by an inner pole magnet arranged on the inner side and an outer pole magnet arranged on the outer side of the inner pole magnet, the outer pole magnet having larger magnetic line density than the inner pole magnet; and
a target arranged on a front surface of said unbalanced magnetic field formation means, wherein
the film formation apparatus has an AC power source, and
said AC power source applies alternating current whose polarity is switched with a frequency of 10 kHz or more between said target of one of said sputtering evaporation sources and said target of the other sputtering evaporation source among the two sputtering evaporation sources.

2. The film formation apparatus according to claim 1, wherein
the inner pole magnets of said two sputtering evaporation sources have the same pole as each other, and the outer pole magnets have the same pole as each other.

3. The film formation apparatus according to claim 1, wherein
a shutter covering a front surface of said target is openably and closably provided on a front surface of said sputtering evaporation source, and
the shutter has an open angle of 90° or more at the time of full open.

4. The film formation apparatus according to claim 1, further comprising:
a cathodic discharge type arc evaporation source in said vacuum chamber.

5. The film formation apparatus according to claim 1, further comprising:
a gas supply means for supplying a mixture gas of a reactive gas and an inert gas into said vacuum chamber.

6. A film formation method for performing film formation by using the film formation apparatus according to claim 1, wherein
by applying the alternating current by said AC power source, the film formation is performed while discharge is generated between said targets of said two sputtering evaporation sources.

7. The film formation method according to claim 6, wherein
by supplying a mixture gas of a reactive gas and an inert gas into said vacuum chamber and ionizing the mixture gas with using the discharge, a CVD film is formed.

8. The film formation method according to claim 7, wherein
the reactive gas is a nitrogen gas.
